# EUROPEAN PATENT APPLICATION

(11) **EP 0 535 979 A2**
(43) Date of publication of application: **07.04.1993**
(21) Application number: 92309018.7
(22) Date of filing: 02.10.1992
(51) Int. Cl.: H01L 29/784, H01L 21/336

(54) **A thin film transistor and a method for producing the same**

(30) Priority: 02.10.1991 JP 255525/91; 31.10.1991 JP 286739/91
(71) Applicant: SHARP KABUSHIKI KAISHA, Osaka 545 (JP)
(72) Inventor: Ikubo, Katsumasa, Tenri-shi, Nara-ken (JP); Tanaka, Hirohisa, Ikoma-gun, Nara-ken (JP); Mitani, Yasuhiro, Habikino-shi, Osaka (JP); Morimoto, Hiroshi, Kitakatsuragi-gun, Nara-ken (JP)
(74) Representative: Brown, Kenneth Richard

(57) **Abstract**

A thin film transistor which includes a lamination provided on an insulating substrate. The lamination includes a gate electrode, a gate insulating film, and a semiconductor layer which is formed of microcrystalline silicon. The thin film transistor further includes a source electrode and a drain electrode provided on the lamination. The source electrode and the drain electrode have an appropriate space therebetween.

## Description

### BACKGROUND OF THE INVENTION

### 1. Field of the Invention:

The present invention relates to a thin film transistor (hereinafter, referred to as TFT) used as a switching element in a liquid crystal display device or the like, and a method for producing the same.

### 2. Description of the Prior Art:

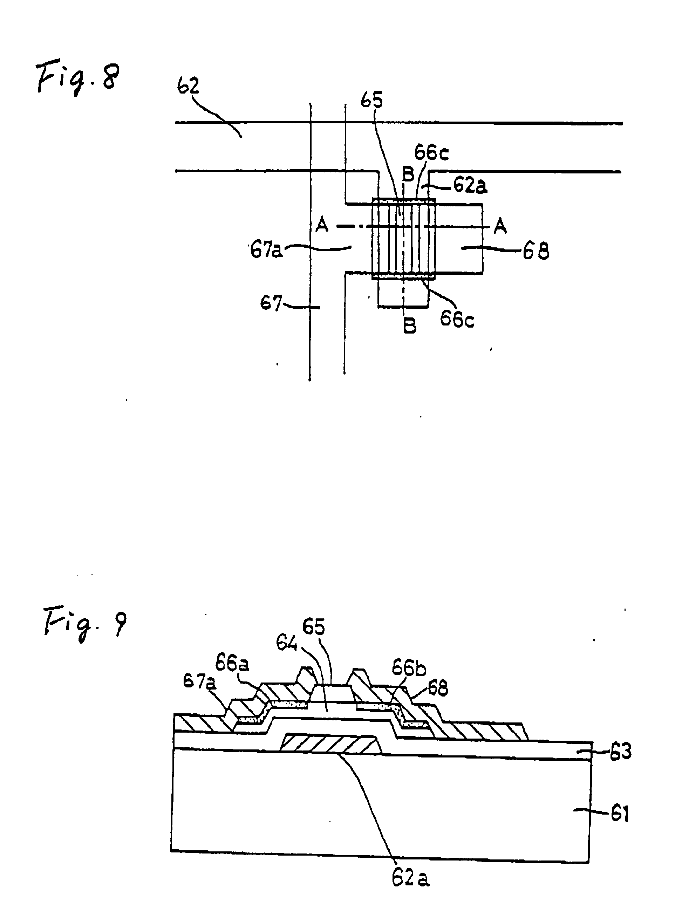

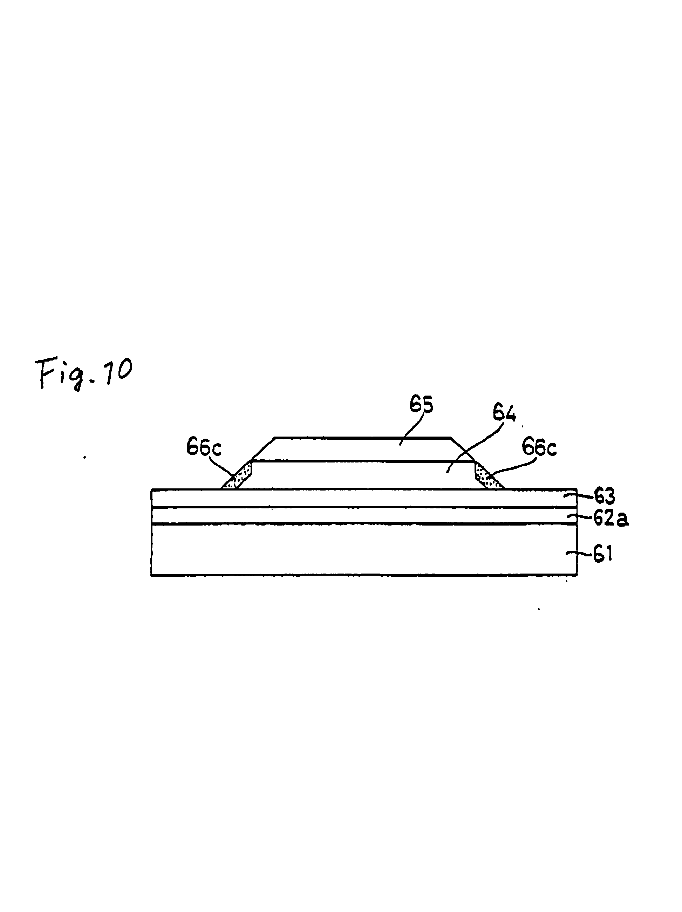

As a TFT, the one shown in Figures 8 through 10 is known. Figure 8 is a plan view of a conventional TFT, Figure 9 is a cross sectional view taken along the line A-A of Figure 8, and Figure 10 is a cross sectional view taken along the line B-B of Figure 8.

As is shown in Figure 8, the TFT is formed in the vicinity of an intersection of a gate bus line 62 and a source bus line 67 both provided on an insulating substrate 61. As is shown in Figure 9, the TFT includes a gate electrode 62a branched from the gate bus line 62, a gate insulating film 63 provided on the insulating substrate 61 to cover the gate electrode 62a, and a semiconductor layer 64 provided on a portion of the gate insulating film 63, the portion being above the gate electrode 62a.

On a portion of the semiconductor layer 64, a channel passivation film 65 is provided. By implanting an ion from above the channel passivation film 65, contact layers 66a and 66b are formed at upper portions of the semiconductor layer 64, while no contact layer is formed at the portion of the semiconductor layer 64 in contact with the channel passivation film 65. A source electrode 67a branched from the source bus line 67 is provided on the contact layer 66a and a portion of the gate insulating film 63 in the vicinity thereof, and a drain electrode 68 is provided on the contact layer 66b and a portion of the gate insulating film 63 in the vicinity thereof.

In the above-mentioned conventional TFT, an ion is implanted from above the channel passivation film 65. Accordingly, the upper portions of the semiconductor layer 64 are easily doped with the ion, whereby the contact layers 66a and 66b are easily formed at the upper portions. On the other hand, since side portions of the semiconductor layer 64 are difficult to dope with the ion, it is difficult to form contact layers at the side portions. For this reason, the source electrode 67a is in contact with the semiconductor layer 64 through one of the side portions where no contact layer is formed, and the drain electrode 68 is in contact with the semiconductor layer 64 through the other side portion where no contact layer is formed. This causes a leak current to flow between the source electrode 67a and the semiconductor layer 64, and between the drain electrode 68 and the semiconductor layer 64. The leak current raises the off-current (IoffO thereby lowering characteristics of the TFT.

As is shown in Figure 10, an ion is also implanted to portions 66c of the semiconductor layer 64 which are not covered with the channel passivation film 65 and are exposed outside. This causes a leak current to flow between the source electrode 67a and the drain electrode 68, resulting in inferior characteristics of the TFT.

Such a TFT, which uses amorphous silicon (hereinafter, referred to as a-Si) for the semiconductor layer 64, is referred to as an a-Si TFT. An a-Si TFT is advantageous in that a-Si is formed into a thin film over a large area at a relatively low temperature. However, an a-Si TFT does not operate at a high speed due to a small field mobility of a Si, which is only approximately 0.5 cm2N.s. As a liquid crystal display device is now required to have a larger and larger display capacity, a switching device operating at a high speed is demanded. It is difficult to apply an a-Si TFT which does not operate at a high speed to a high precision display device such as a high definition TV.

A TFT including a semiconductor layer formed of polysilicon having a field mobility of 100 cm²N.s or more has no problem in terms of field mobility, but requires a high temperature to form a thin film. Accordingly, an expensive substrate should be used instead of an inexpensive glass, which raises production cost. Moreover, since such a TFT has a larger absorption coefficient in a visible light region than an a-Si TFT, the leak current caused by light emission is large.

### SUMMARY OF THE INVENTION

The thin film transistor according to the present invention includes an insulating substrate and a lamination provided on the insulating substrate. The lamination include a gate electrode, a semiconductor layer formed of microcrystalline silicon, and a gate insulating film interposed between the gate electrode and the semiconductor layer. The thin film transistor further includes a source electrode and a drain electrode provided on the semiconductor layer. The source electrode and the drain electrode have an appropriate space therebetween.

Alternatively, the thin film transistor includes an insulating substrate; a gate provided on the insulating substrate; a first insulating film provided on the insulating substrate to cover the gate; a semiconductor layer provided on the first insulating film in the state of being insulated from the gate by the first insulating film; a second insulating film provided on the semiconductor layer, the second insulating film having two contact holes; and a source and a drain provided on the second insulating film in the state of being separated from each other, the source and the drain being in contact with the semiconductor layer through the contact holes of the second insulating film. A portion of the semiconductor layer in contact with the source and another portion of the semiconductor layer in contact with the drain are doped with an impurity.

Alternatively, the method for producing a thin film transistor of the present invention includes the steps of sequentially laminating a gate, a first insulating film, a semiconductor layer and a second insulating film on an insulating substrate; forming a pair of contact holes in the second insulating film, the contact holes reaching the semiconductor layer; implanting an impurity to the semiconductor layer through the contact holes of the second insulating film; and laminating a source and a drain on the second insulating film so as to be in contact with the semiconductor layer through the contact holes of the second insulating film, respectively.

Thus, the invention described herein makes possible the advantages of providing (1) a thin film tran- sistorwhich has a large field mobility and thus can be applied to a high precision display device as well as being produced at low cost; and (2) a thin film transistor having satisfactory characteristics with substantially no leak current and a method for producing such a thin film transistor.

These and other advantages of the present invention will become apparent to those skilled in the art upon reading and understanding the following detailed description with reference to the accompanying figures.

### BRIEF DESCRIPTION OF THE DRAWINGS

Figure 1 is a cross sectional view of a thin film transistor according to a first example of the present invention.
Figure 2 is a cross sectional view of a thin film transistor according to a second example of the present invention.
Figure 3 is a cross sectional view of a thin film transistor according to a third example of the present invention.
Figure 4 is a cross sectional view of a thin film transistor according to a fourth example of the present invention.
Figure 5 is a cross sectional view of a thin film transistor according to a fifth example of the present invention.
Figure 6 is a cross sectional view of a thin film transistor according to a sixth example of the present invention.
Figures 7a through 7d are cross sectional views illustrating production stages of the thin film transistor of Figure 6.
Figure 8 is a plan view of a conventional thin film transistor.
Figure 9 is a cross sectional view taken along the line A-A of Figure 8.
Figure 10 is a cross sectional view taken along the line B-B of Figure 8.

### DESCRIPTION OF THE PREFERRED EMBODIMENTS

Hereinafter, the present invention will be described by way of illustrating examples with reference to the accompanying drawings.

### Example 1

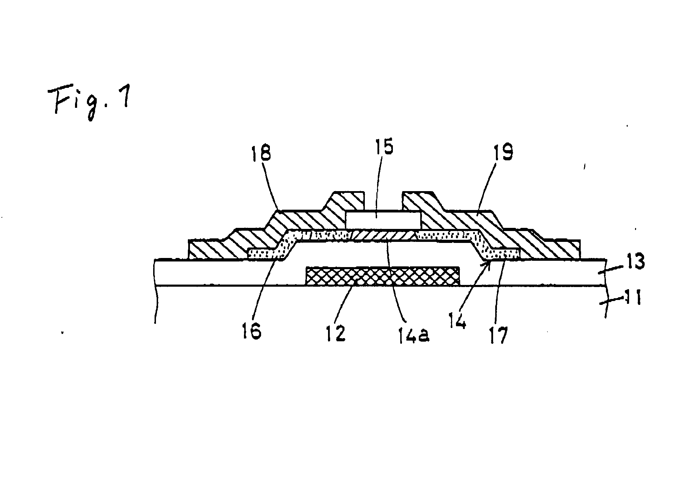

Figure 1 is a cross sectional view of a TFT according to a first example of the present invention. As is shown in Figure 1, the TFT includes a glass substrate 11, a gate electrode 12 provided on the glass substrate 11, a gate insulating film 13 provided on an entire surface of the glass substrate 11 to cover the gate electrode 12, and a semiconductor layer 14 provided on a portion of the gate insulating film 13, the portion being above the gate electrode 12.

The semiconductor layer 14 is divided into three regions: an active region 14a disposed in a central area and contact layers 16 and 17 disposed in both side areas. The active region 14a is formed of microcrystalline silicon, and the contact layers 16 and 17 are formed of microcrystalline silicon doped with an impurity. The active region 14a is covered with an insulating channel passivation film 15. As mentioned later, the contact layers 16 and 17 are formed after the formation of the channel passivation film 15 by implanting the impurity into the semiconductor layer 14 using the channel passivation film 15 as a mask.

A source electrode 18 is provided on the gate insulating film 13 to cover the contact layer 16 and a portion of the channel passivation film 15. A drain electrode 19 is provided on the gate insulating film 13 to cover the contact layer 17 and a portion of the channel passivation film 15.

The TFT having the above-mentioned construction is produced in the following manner.

First, Ta or the like is deposited on the glass substrate 11 in a thickness of 200 nm to form the gate electrode 12.

Next, SiNₓ or the like is deposited in a thickness of 300 nm on an entire surface of the glass substrate 11 to coverthe gate electrode 12, therebyforming the gate insulating film 13. Microcrystalline silicon is deposited on the gate insulating film 13 in a thickness of, for example, 100 nm, and then the resultant microcrystalline silicon film is patterned to form the semiconductor layer 14. The formation of the microcrystalline silicon film is effected by a plasma CVD method using a mixed gas containing SiH₄ and H₂ in a volume ratio of 1:10 at a temperature of the glass substrate 11 of 350°C, a gas pressure of 0.1 Torr, and an r.f. power density of 0.1 W/cm².

Then, SiNₓ or the like is deposited on the semiconductor layer 14 in a thickness of 200 nm to form the channel passivation film 15. Phosphorus ion as an impurity is implanted into the semiconductor layer 14 using the channel passivation film 15 as a mask, thereby forming the contact layers 16 and 17. As a result, an area of the semiconductor layer 14 below the channel passivation film 15 remains without impurity. This area acts as the active region 14a. The contact layers 16 and 17 each have the impurity in a content of 10¹⁹/_{CM}³ or more, preferably in the range of 5 x 10¹⁹ to 5 x 10²¹/cm3.

Finally, Mo or the like is deposited in a thickness of 200 nm to form the source electrode 18 and the drain electrode 19.

In the TFT according to the first example, the active region 14a is formed of substantially pure microcrystalline silicon having a large electric field mobility. Accordingly, the TFT operates at a high speed. Since microcrystalline silicon has a smaller absorption coefficient in a visible light region than a-Si, the leak current caused by light emission can be small. Moreover, since the temperature forforming a thin film can be as low as 350°C, an inexpensive glass can be used as the substrate, resulting in low production cost.

### Example 2

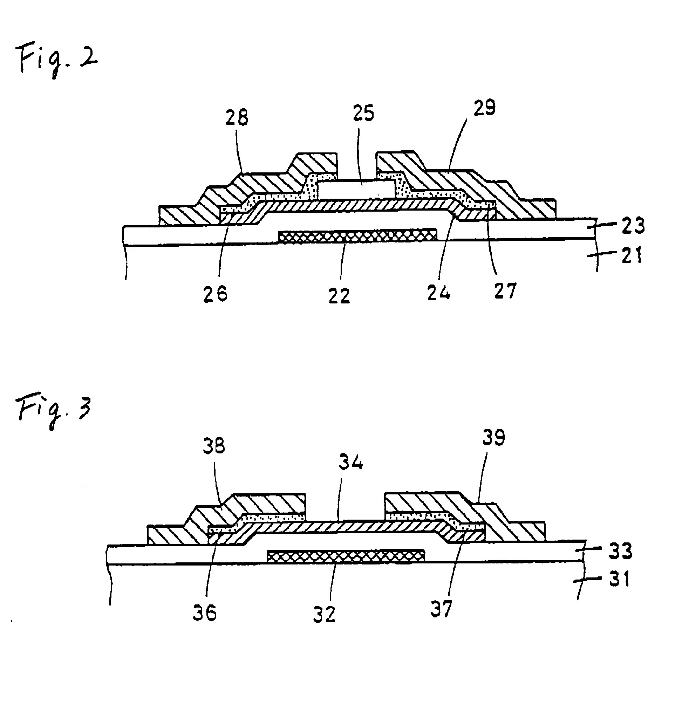

Figure 2 is a cross sectional view of a TFT according to a second example of the present invention. The TFT according to the second example is distinct from the TFTs according to the first example in the position of the contact layers. In the TFT according to the second example, a gate electrode, a gate insulating film and a semiconductor layer are sequentially laminated on a glass substrate, and contact layers are provided on the semiconductor layer, namely without contacting the gate insulating film.

Practically, the TFT includes a glass substrate 21, a gate electrode 22 provided on the glass substrate 21, and a gate insulating film 23 provided on an entire surface of the glass substrate 21 to cover the gate electrode 22. On the gate insulating film 23, a semiconductor layer 24 formed of microcrystalline silicon is provided at a position above the gate electrode 22 in a larger area than the gate electrode 22. Achan- nel passivation film 25 is provided on a central portion of the semiconductor layer 24. Contact layers 26 and 27 interposing the channel passivation film 25 are also provided on the semiconductor layer 24. The contact layers 26 and 27 have a gap therebetween on the channel passivation film 25.

A source electrode 28 is provided on the gate insulating film 23 to cover the contact layer 26, and a drain electrode 29 is provided on the gate insulating film 23 to cover the contact layer 27.

The TFT having the above-mentioned construction is produced in the following manner.

Cr or the like is deposited on the glass substrate 21 in a thickness of 100 nm to form the gate electrode 22. Si0₂ or the like is deposited in a thickness of 200 nm on an entire surface of the glass substrate 21 to cover the gate electrode 22, thereby forming the gate insulating film 23. Microcrystalline silicon is deposited on the gate insulating film 23 in a thickness of, for example, 100 nm under the same conditions as in the first example, and then the resultant microcrystalline silicon film is patterned to form the semiconductor layer 24. Then, SiNₓ or the like is deposited on the semiconductor layer 24 in a thickness of 200 nm to form the channel passivation film 25.

Microcrystalline silicon doped with phosphorus ion as an impurity is deposited in a thickness of 50 nm on the semiconductor layer 24, and then the resultant microcrystalline silicon film is patterned to partially cover the channel passivation film 25, thereby forming the contact layers 26 and 27. Accordingly, the contact layers 26 and 27 are formed of a different material from that of the semiconductor layer 24. The formation of the contact layers 26 and 27 is effected by a plasma CVD method using a mixed gas containing SiH₄, H₂ and PH₃ in a volume ratio of 1:30:0.01 at a temperature of the glass substrate 21 of 250°C, a gas pressure of 0.1 Torr, and an r.f. power density of 0.1 W/cm². The contact layers 26 and 27 each have the impurity in a content of 10¹⁹/_{CM}³ or more, preferably of approximately 5 x 10²⁰/cm³.

Finally, Mo or the like is deposited in a thickness of 200 nm to form the source electrode 28 and the drain electrode 29.

In the TFTaccording to the second example also, since the semiconductor layer 24 is formed of substantially pure microcrystalline silicon, the same effects as in the TFTs according to the first example can be obtained.

### Example 3

Figure 3 is a cross sectional view of a TFT according to a third example of the present invention. The TFT according to the third example is identical with the TFT according to the second example except that a channel passivation film is not provided.

The TFT according to the third example is produced in the following manner.

First, Cr or the like is deposited on a glass substrate 31 in a thickness of 100 nm to form a gate electrode 32. Next, Si02 orthe like is deposited in a thickness of 200 nm on an entire surface of the glass substrate 31 to coverthe gate electrode 32, thereby forming a gate insulating film 33. Microcrystalline silicon is deposited on the gate insulating film 33 in a thickness of, for example, 100 nm, and then the resultant microcrystalline silicon film is patterned to form a semiconductor layer 34. a-Si doped with phosphorus ion or the like as an impurity is deposited on the semiconductor layer 34 in a thickness of 50 nm, and then the resultant a-Si film is patterned to form contact layers 36 and 37. Accordingly, the contact layers 36 and 37 are formed of a different material from that of the semiconductor layer 34. Finally, Ti or the like is deposited in a thickness of 200 nm to form a source electrode 38 and a drain electrode 39.

In the TFT according to the third example also, since the semiconductor layer 34 is formed of substantially pure microcrystalline silicon, the same effects as in the TFTs according to the preceding examples can be obtained.

### Example 4

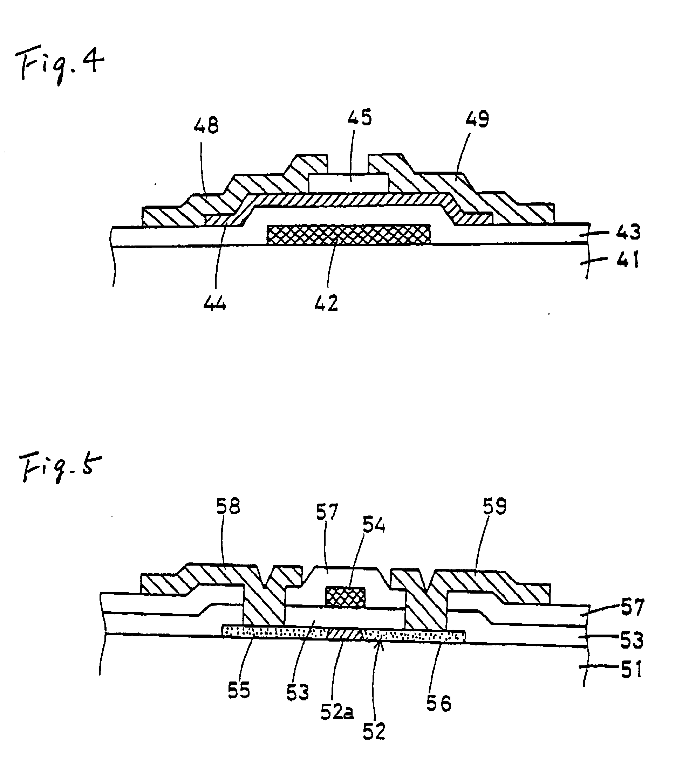

Figure 4 is a cross sectional view of a TFT according to a fourth example of the present invention. In the TFT according to the fourth example, no contact layer is provided between a source electrode and a semiconductor layer or between a drain electrode and the semiconductor layer.

Practically, the TFT according to the fourth example includes a glass substrate 41, a gate electrode 42 provided on the glass substrate 41, and a gate insulating film 43 provided on an entire surface of the glass substrate 41 to cover the gate electrode 42. On the gate insulating film 43, a semiconductor layer 44 is provided at a position above the gate electrode 42 in a larger area than the gate electrode 42. A channel passivation film 45 is provided on a central portion of the semiconductor layer 44. A source electrode 48 and a drain electrode 49 are each provided on the gate insulating film 43 so as to partially cover the semiconductor layer 44 and further to reach the channel passivation film 45.

The TFT having the above-mentioned construction is produced in the following manner.

First, Ta or the like is deposited on the glass substrate 41 in a thickness of 200 nm to form the gate electrode 42. Next, Si0₂ or the like is deposited in a thickness of 200 nm on an entire surface of the glass substrate 41 to cover the gate electrode 42, thereby forming the gate insulating film 43. Microcrystalline silicon is deposited in a thickness of 100 nm on the gate insulating film 43, and then the resultant microcrystalline silicon film is patterned to form the semiconductor layer 44. SiNx or t he like is deposited on the semiconductor layer 44 in a thickness of 200 nm to form the channel passivation film 45. Finally, Al or the like is deposited in a thickness of 200 nm to form the source electrode 48 and the drain electrode 49.

In the TFT according to the fourth example also, since the semiconductor layer 44 is formed of substantially pure microcrystalline silicon, the same effects as in the TFTs according to the preceding examples can be obtained.

### Example 5

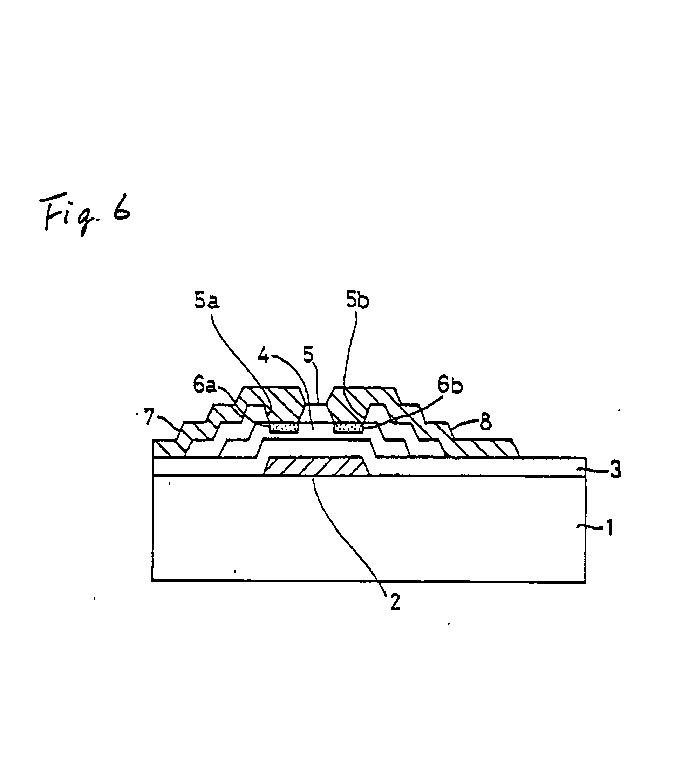

Figure 5 is a cross sectional view of a TFT according to a fifth example of the present invention. The TFT according to the fifth example is distinct from TFTs according to the preceding examples in that a semiconductor layer is provided on a glass substrate and that a gate electrode is provided on a gate insulating film which is provided on the semiconductor layer.

Practically, a semiconductor layer 52 is provided on a glass substrate 51. The semiconductor layer 52 is divided into three regions: an active region 52a disposed in a central area and contact layers 55 and 56 disposed in both side areas. The active region 52a is formed of microcrystalline silicon, and the contact layers 55 and 56 are formed of microcrystalline silicon doped with an impurity.

A gate insulating film 53 is provided on the glass substrate 51 to cover the semiconductor layer 52, and a gate electrode 54 is provided on an area of the gate insulating film 53 above the active region 52a. The gate electrode 54 is covered with a layer insulating film 57. Contact holes are formed through the gate insulating film 53 and the layer insulating film 57 at positions corresponding to the contact layers 55 and 56. The contact layers 55 and 56 are formed afterthe formation of the gate electrode 54 by implanting an impurity into the semiconductor layer 52 using the gate electrode 54 as a mask.

A source electrode 58 is provided to fill the contact hole corresponding to the contact layer 55, and is electrically connected to the contact layer 55. A drain electrode 59 is provided to fill the contact hole corresponding to the contact layer 56, and is electrically connected to the contact layer 56.

The TFT having the above-mentioned construction is produced in the following manner.

First, microcrystalline silicon is deposited on the glass substrate 51 in a thickness of, for example, 100 nm, and then the resultant microcrystalline silicon film is patterned to form the semiconductor layer 52. The formation of the microcrystalline silicon film is effected underthe same conditions as in the first exam- pie, namely, for example, by a plasma CVD method using a mixed gas containing SiH₄ and H₂ in a volume ratio of 1:10 at a temperature of the glass substrate 51 of 350°C, a gas pressure of 0.1 Torr, and an r.f. power density of 0.1 W/cm².

Next, Si0₂ or the like is deposited in a thickness of 200 nm on an entire surface of the glass substrate 51 to cover the semiconductor layer 52, thereby forming the gate insulating film 53. Tungsten or the like is deposited on the gate insulating film 53 in a thickness of 200 nm to form the gate electrode 54. Then, boron ion as an impurity is implanted into the semiconductor layer 52 using the gate electrode 54 as a mask to form the contact layers 55 and 56. As a result, an area of the semiconductor layer 52 below the gate electrode 54 remains without impurity. This area acts as the active region 52a. The contact layers 55 and 56 each have the impurity in a content of 10¹⁹/_{CM}³ or more, preferably in the range of 5 x 10¹⁹ to 5 x 10²¹/_{CM}³.

Then, Si0₂ is deposited in a thickness of 200 nm on an entire surface of the gate insulating film 53 to cover the gate electrode 54, thereby forming the layer insulating film 57. Then, the contact holes are formed through the layer insulating film 57 and the gate insulating film 53 at positions corresponding to the contact layers 55 and 56. Finally, the A1 orthe like is deposited in a thickness of 200 nm on the layer insulating film 57 so as to fill the contact holes, thereby forming the source electrode 58 and the drain electrode 59.

In the TFT according to the fifth example also, since the active region 52a in the semiconductor layer 52 is formed of substantially pure microcrystalline layer, the same effects as in the TFT according to the preceding examples can be obtained.

### Example 6

Figure 6 is a cross sectional view of a TFT according to a sixth example of the present invention. The TFT is formed in the vicinity of an intersection of a gate bus line (not shown) and a source bus line (not shown) both provided on an insulating substrate 1. The TFT includes a gate electrode 2 branched from the gate bus line, a gate insulating film 3 provided on an entire surface of the insulating substrate 1 to cover the gate electrode 2, and a semiconductor layer 4 provided on a portion of the gate insulating film 3, the portion being above the gate electrode 2.

On the semiconductor layer 4, a channel passivation film 5 is provided to cover the semiconductor layer 4. The channel passivation film 5 has two contact holes 5a and 5b reaching an upper surface of the semiconductor layer 4. By implanting an ion from above the channel passivation film 5, contact layers 6a and 6b are formed at two upper portions of the semiconductor layer 4, the portions being right below the contact holes 5a and 5b, while no contact layer is formed at a portion of the semiconductor layer 4 in contact with the channel passivation film 5. A source electrode 7 branched from the source bus line is provided to fill the contact hole 5a and also to reach the gate insulating film 3, covering a surface of the channel passivation film 5. A drain electrode 8 is provided to fill the contact hole 5b and also to reach the gate insulating film 3, covering a surface of the channel passivation film 5.

The TFT having the above-mentioned construction is produced in the following manner.

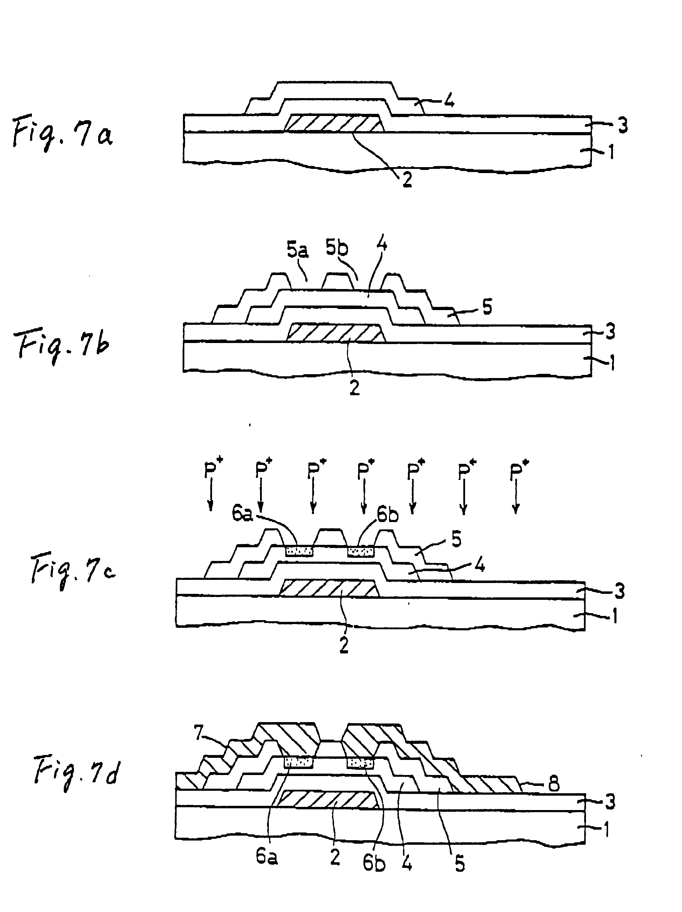

As is shown in Figure 7a, Ta is deposited on the insulating substrate 1 in a thickness of 100 to 500 nm, preferably 300 nm, by use of a sputtering method or the like, and then the resultant Ta film is patterned to form the gate electrode 2.

Next, SiNₓ or the like is deposited on an entire surface of the insulating substrate 1 to cover the gate electrode 2 to form the gate insulating film 3. DiNₓ is deposited in a thickness of 100 to 500 nm, preferably 300 nm, by use of a plasma CVD method or the like.

On a portion of the gate insulating film 3 right above the gate electrode 2, a-Si is deposited in a thickness of 10 to 50 nm, preferably 50 nm, by use of a plasma CVD method or the like, and then the resultant a-Si film is patterned to form the semiconductor layer 4.

As is shown in Figure 7b, an insulating material such as SiNₓ is deposited on an entire surface of the insulating substrate 1 to cover the semiconductor layer 4 in a thickness of 100 to 500 nm, preferably 200 nm, by use of a plasma CVD method orthe like, thereby forming the channel passivation film 5. Then, the contact holes 5a and 5b are formed in the channel passivation film 5.

As is shown in Figure 7c, phosphorus ion or boron ion as an impurity is implanted to the semiconductor layer4 from above the channel passivation film 5, preferably at an acceleration voltage of 1 to 100 kV. Thus, the contact layers 6a and 6b are formed at the portions of the semiconductor layers 4 right below the contact holes 5a and 5b.

As is shown in Figure 7d, Ti or Mo is deposited in a thickness of approximately 300 nm by use of a sputtering method orthe like, and then the resultant metal film is patterned to form the source electrode 7 so as to fill the contact hole 5a and also to reach the gate insulating film 3, covering the channel passivation film 5. Simultaneously, the drain electrode 8 is formed to fill the contact hole 5b and also to reach the gate insulating film 3, covering a surface of the channel passivation film 5 in the same manner.

In the TFT produced in the above-mentioned manner, the channel passivation film 5 has the contact hole 5a for connecting the semiconductor layer 4 and the source electrode 7 and the contact hole 5b for connecting the semiconductor layer 4 and the drain electrode 8. Therefore, the ion as an impurity is implanted to the semiconductor layer4 through the contact holes 5a and 5b, thereby forming the contact layers 6a and 6b only at the portions of the semiconductor layer 4 right below the contact holes 5a and 5b. The semiconductor layer 4 is covered with the channel passivation film 5 except these portions.

In such a construction, a portion of the semiconductor layer which is not doped with the ion is covered with the channel passivation film 5. Accordingly, neither the source electrode 7 nor the drain electrode 8 is in direct contact with the portion of the semiconductor layer 4 which is not doped with the ion. Since the source electrode 7 and the drain electrode 8 are in direct contact with the contact layers 6a and 6b doped with the ion, respectively, generation of a leak current is prevented between the source electrode 7 and the contact layer 6a, and between the drain electrode 8 and the contact layer 6b. It does not occur either that a leak current flows between the source electrode 7 and the drain electrode 8 since the semiconductor layer 4 is entirely covered with the channel passivation film 5 except the contact layers 6a and 6b.

Since a-Si is used as a material of the semiconductor layer 4 in the sixth example, heating can be performed at a low temperature. Accordingly, the insulating substrate 1 can be formed of an inexpensive glass which is not resistant to a high temperature. This fact contributes to lower production cost. The same advantage can be offered in the case when microcrystalline silicon, which has crystals scattered in an amorphous state, is used instead of a-Si.

A TFT using microcrystalline silicon for a semiconductor layer operates at a high speed because of the large field mobility of microcrystalline silicon. Moreover, since microcrystalline silicon has a larger absorption coefficient in a visible light region than a-Si, the leak current caused by light emission is small.

Accordingly, in a TFT according to the present invention, since the leak current can be lowered as has been described, the off-current (loft) can be reduced, thereby enhancing the TFT characteristics. Further, the use of a-Si or microcrystalline silicon for a semiconductor layer allows an inexpensive glass to be used, thereby lowering production cost.

Various other modifications will be apparent to and can be readily made by those skilled in the art without departing from the scope and spirit of this invention. Accordingly, it is not intended that the scope of the claims appended hereto be limited to the description as set forth herein, but rather that the claims be broadly construed.

There are described above novel features which the skilled man will appreciate give rise to advantages. These are each independent aspects of the invention to be covered by the present application, irrespective of whether or not they are included within the scope of the following claims.

## Claims

1. A thin film transistor, comprising:
an insulating substrate;
a lamination provided on the insulating substrate, the lamination including a gate electrode, a semiconductor layer formed of microcrystalline silicon, and a gate insulating film interposed between the gate electrode and the semiconductor layer; and
a source electrode and a drain electrode provided on the semiconductor layer, the source electrode and the drain electrode having an appropriate space therebetween.

2. Athinfilmtransistoraccordingtoclaim1,wherein the source electrode and the semiconductor layer interpose a contact layer therebetween, and the drain electrode and the semiconductor layer interpose another contact layer therebetween.

3. Athin film transistor according to claim 1, wherein the gate electrode is provided on the side of the insulating substrate, and the source electrode and the drain electrode are directly provided on the semiconductor layer, the source electrode and the drain electrode interposing a different insulating film therebetween which is provided on the semiconductor layer.

4. Athin film transistor according to claim 3, wherein areas of the semiconductor layer in contact with the source electrode and the drain electrode are doped with an impurity for changing the conductivity.

5. Athin film transistor according to claim 1, wherein the gate electrode is provided on the side of the insulating substrate, and the source electrode and the drain electrode are respectively provided on contact layers which are provided on the semiconductor layer, the source electrode and the drain electrode interposing a different insulating film therebetween.

6. Athin film transistor according to claim 1, wherein the semiconductor layer is provided on the side of the insulating substrate, and the gate electrode is provided on an area of the insulating film.

7. Athin film transistor according to claim 6, wherein the semiconductor layer except for an area thereof corresponding to the gate electrode is doped with an impurity for changing the conductivity.

8. Athin film transistor according to claim 7, wherein the gate electrode is covered with a different insulating film, and the source electrode and the drain electrode are provided on the different insulating film and are further respectively connected to areas of the semiconductor layer doped with the impurity through throughholes formed in the different insulating film and the insulating film.

9. A thin film transistor, comprising:
an insulating substrate;
a gate provided on the insulating substrate;
a first insulating film provided on the insulating substrate to cover the gate;
a semiconductor layer provided on the first insulating film in the state of being insulated from the gate by the first insulating film;
a second insulating film provided on the semiconductor layer, the second insulating film having two contact holes; and
a source and a drain provided on the second insulating film in the state of being separated from each other, the source and the drain being in contact with the semiconductor layer through the contact holes of the second insulating film,
wherein a portion of the semiconductor layer in contact with the source and another portion of the semiconductor layer in contact with the drain are doped with an impurity.

10. A thin film transistor according to claim 9, wherein the semiconductor layer is formed of amorphous silicon.

11. Athin film transistor according to claim 9, wherein the semiconductor layer is formed of a silicon in a microcrystalline state, which has crystals scattered in an amorphous state.

12. A method for producing a thin film transistor, comprising the steps of:
sequentially laminating a gate, a first insulating film, a semiconductor layer and a second insulating film on an insulating substrate;
forming a pair of contact holes in the second insulating film, the contact holes reaching the semiconductor layer;
implanting an impurity to the semiconductor layer through the contact holes of the second insulating film; and
laminating a source and a drain on the second insulating film so as to be in contact with the semiconductor layer through the contact holes of the second insulating film, respectively.

13. Athin-film transistor characterised by a semiconductor layer (14) having an active region (14a) of substantially pure microcrystalline silicon.

14. Athin-film transistor according to claim 13, characterised by contact layers (26, 27; 36, 37) for source and drain electrodes (28, 29; 38, 39) which contact layers are distinct from, but in contact with, said semiconductor layer (24; 34).

15. An active matrix substrate for a display device, the substrate comprising an array of thin-film transistors, each in accordance with any one of claims 1 to 11, 13 and 14.
